# EUROPEAN PATENT APPLICATION

(11) **EP 4 083 648 A1**
(43) Date of publication of application: **02.11.2022**
(21) Application number: 21020242.0
(22) Date of filing: 30.04.2021
(51) Int. Cl.: G01R 33/34

(54) **COIL MODULE FOR MAGNETIC RESONANCE IMAGING APPLICATIONS**

(71) Applicant: Medizinische Universität Wien, 1090 Wien (AT)
(72) Inventor: Laistler, Elmar, A-1070 Vienna (AT); Nohava, Lena, A-1170 Vienna, Austria Vienna (AT); Obermann, Michael, A-1180 Vienna, Austria Vienna (AT); Roat, Sigrun, A-1190 Vienna (AT)
(74) Representative: Keschmann, Marc

(57) **Abstract**

A coil module for magnetic resonance imaging applications is provided, comprising:
- at least one flexible radio frequency coil,
- a housing, wherein said housing encloses an interfacing circuitry electrically connected to the at least one coil,
- two flexible cover layers for entirely covering the at least one coil outside said housing, wherein the at least one coil is arranged between said two cover layers, and
- connecting means for connecting the coil module to at least one adjacent coil module.

## Description

The invention refers to a coil module for magnetic resonance imaging applications. Further, the invention refers to an array of coils for magnetic resonance imaging applications, comprising at least two coil modules.

Magnetic resonance imaging (MRI) is a process for non-invasively obtaining images from the inside of the human body without ionizing radiation, only involving static and time-varying electromagnetic fields. The obtained image quality in MRI depends critically on the sensitivity of the signal detection process. This sensitivity can be influenced by the design of the detector, i.e. the radio frequency (RF) coil. There exists an optimal size of RF coil elements for a given target depth inside the sample, which is generally much smaller than the area to be covered along the sample's surface. Therefore, multiple size-optimized RF coil elements are employed to cover a larger field of view and optimize sensitivity for the desired target depth at the same time. Since RF coil elements are generally resonant at the desired Larmor frequency, strong electromagnetic coupling arises when two (or more) RF coil elements are placed close to each other. Nearest adjacent elements can be decoupled by choosing the correct overlap between them - this is based on the principle of net flux cancellation, as described in P.B. Roemer, W.A. Edelstein, C.E. Hayes, S.P. Souza and O.M. Mueller, "The NMR phase array", Magnetic Resonance in Medicine 16(2): 192-225, 1990. By having the coils overlap as described here, the mutual inductance is substantially zero.

In addition, following basic electromagnetic laws in the quasi-static regime, RF coil sensitivity is maximum in the vicinity of the conductive structures. Therefore, strong sensitivity gain can be achieved by placing the RF coil elements as close to the sample as possible. With rigid RF coil elements made of stiff copper wire, encapsulated in rigid housings (typically made of a plastic material) together with the fact that human body shapes vary considerably from person to person, a rigid RF coil element cannot be built in a shape so that it closely follows the body surface for a large range of body shapes. This leads to suboptimal sensitivity and, therefore, reduced image quality with rigid coils. Furthermore, rigid coil elements tend to be bulky, heavy and hence cumbersome in clinical use.

As used herein, a radio frequency coil is understood to refer to a RF detector to capture the MR signal from the sample (e.g. human tissue) that is connected to one of the MR scanner system's receive channels.

Therefore, the invention aims at providing an improved coil module that can adapt to the individual shape of the body part to be scanned. Further, the coil module shall enable a flexible adaptation to the size of the body part to be scanned.

In order to solve this object, the invention provides a Coil module for magnetic resonance imaging applications, comprising:
- at least one flexible radio frequency coil,
- a housing, wherein said housing encloses an interfacing circuitry electrically connected to the at least one coil,
- two flexible cover layers for entirely covering the at least one coil outside said housing, wherein the at least one coil is arranged between said two cover layers, and
- connecting means for connecting the coil module to at least one adjacent coil module.

The coil module of the invention allows a flexible arrangement of coils that can be form-fitted to any body shape. In particular, the one or more coils are at least partly arranged outside the housing, so that they are not confined to the rigid shape of the housing. For protecting the coil(s) outside of the housing, two flexible cover layers are provided, one above the coil(s) and one below the coil(s) so that the coil(s) is/are arranged between the two cover layers. In this way, the cover layers provide a protective enclosure of the coil(s). In order to ensure mechanical flexibility of the coil(s), the cover layers are made of a flexible material, such as a textile material or a fabric.

The enclosure provides mechanical robustness to avoid damage of the coil(s) during storage, handling, and operation. In order to enhance protection of the coil(s), a preferred embodiment provides that a cushion layer is each arranged between a cover layer and the at least one coil.

Further, the enclosure made from the two cover layers may provide electrical insulation between conductive parts of the coil module and the body part to be scanned, so as to fulfill legal safety requirements. Therefore, the cover layers may preferably be made from an electrically insulating material, such as a medical grade synthetic leather for providing electrical insulation.

Further, the cover layers are preferably made from material that can be disinfected.

Preferably, the cover layers are connected with each other in their periphery, in order to form a closed pocket for housing the coil(s).

The coil module may be integrated into a piece of clothing, such as a vest adapted to cover at least part of a thorax of a patient, or a hood, a sleeve, stockings, or trousers. In this way, the invention provides a wearable coil module for magnetic resonance imaging applications. In this connection, at least on of said two cover layers may be designed as, or integrated into, a cloth of the piece of clothing.

According to the invention, the coil module comprises connecting means for connecting the coil module to at least one adjacent coil module. In this way, at least two, or a plurality of, coil modules may be connected to one another for creating a larger array of coils, thereby flexibly adapting the size and the shape of the array to the body part to be scanned. The coil module may preferably comprise a plurality of coils that are arranged in a regular pattern so that identical such coil modules may be combined with each other to create an array of coils in a regular pattern.

The coil(s) may be designed in any shape that is suitable for their functioning as a RF detector to capture a MR signal from the body part to be scanned by MRI applications. Possible shapes include, but are not limited to, circular, rectangular, square and elliptic. According to a preferred embodiment, the at least one coil has a circular shape. If a plurality of coils is provided, all coils preferably have the same shape and the same dimension.

In order to cover a larger area of the body part to be scanned, the coil module preferably comprises at least two, preferably at least three, flexible radio frequency coils, wherein each of said coils overlaps with an adjacent coil, in particular such that the mutual inductance is substantially zero. In case of circular coils, the mutual inductance is substantially zero, if the distance between the centers of two adjacent coils corresponds to approximately 0.78 times the diameter of each coil.

Preferably, the coil module comprises at least three flexible radio frequency coils, each coil having a circular shape with a center, wherein the centers of three of said at least three circular coils are arranged at corners of an equilateral triangle. In this way, a pattern is obtained that can be multiplied by connecting two or more coil modules by attaching adjacent coil modules by means of the connecting means. Alternatively, the coils may be arranged in a group of seven coils arranged in a hexagonal pattern. Alternatively, the coils may be arranged in a group of four coils arranged in a rhomboidal pattern.

In order to magnetically decouple the coils of one coil module from adjacent coils of another coil module, the connecting means are preferably arranged to obtain an overlap between a coil of the coil module and a coil of the adjacent coil module, in particular such that the mutual inductance is substantially zero. Thus, the connecting means define the relative position of the coils of one coil module relative to the coils of the adjacent coil module.

Preferably, the connecting means comprise male and female connecting means that are designed to engage with each other, wherein the male and the female connecting means are arranged such that the male connecting means are engageable with the female connecting means, if the coil module is connected to an identical adjacent coil module. In this way, two or more identical coil modules may be combined to form a larger array of coils.

Preferably, the connecting means are designed to define an orientation of the coil module relative to the adjacent coil module.

Preferably, the connecting means are designed for establishing a form-fit connection, such as snap buttons, zippers or hook-and-loop fasteners.

The housing of the coil module of the invention encloses the interfacing circuitry that interfaces the coils with the MR scanner system's receive channels. In other words, the coils of the coil module share common interfacing electronics. Preferably, the interfacing circuitry is arranged on a rigid printed circuit board. Preferably, two or more rigid printed circuit boards are arranged one on top of another, in order to reduce the dimension of the housing and thus to reduce the area that the housing occupies from the overall extension of the coil module, which increases the flexibility of the assembly.

Preferably, the housing is arranged in a middle area of the coil module, wherein the coils are radiating outwardly from the housing. In particular, the at least one coil or the plurality of coils comprise(s) a section that extends into the housing and is connected to the interfacing circuitry.

The coils may surround the housing at substantially regular angular intervals.

Preferably, the housing penetrates an opening in each of the two cover layers.

In order to provide a secure, easy and reversible fixation of the cover layer to the housing in a region where the housing penetrates the opening of the cover layers, a preferred embodiment provides that the housing comprises a clamping member for clamping each of the two cover layers in a rim section of the opening of the respective cover layer.

Preferably, the housing comprises an annular gap between the clamping member and a base region of the housing, wherein the rim section of the opening of the two cover layers is each arranged within said gap, and wherein the clamping member is arranged to be pressed against said rim section.

In order to enhance the fixation of the cover layers to the housing, a preferred embodiment provides that the clamping member, on its side facing the base region of the housing, and the base region, on its side facing the clamping member, comprise protrusions, such as spikes, and/or (a) sharp edge(s). Said protrusions or sharp edge(s) are pressed into the flexible material of the cover layers when clamping the cover layers between the clamping member and the base region of the housing.

Preferably, the housing comprises a main part and a cover part, wherein the cover part and the main part have mating male and female threads for screwing the cover part onto the main part, and wherein the clamping member is guided on the main part in a direction of an axis of said threads and arranged to be pressed against one of said two cover layers when the cover part is screwed relative to the main part. The removable cover part provides an easy maintenance access to the interfacing circuitry that is arranged within the housing.

The clamping member is preferably designed as a clamping ring.

According to a further aspect, the invention provides an array of coils for magnetic resonance imaging applications, comprising at least two coil modules of the invention, wherein said at least two coil modules are connected with each other by means of said connecting means, so that coils of the two coil modules overlap each other, in particular such that the mutual inductance is substantially zero.

Preferably, the coils of said at least two coil modules have a circular shape with a center, wherein said at least two coil modules are arranged relative to one another such that a coil of one of the at least two coil modules, together with two adjacent coils of the other of the at least two coil modules, forms a set of three coils, the centers of the coils of said set of three coils being arranged at corners of an equilateral triangle.

The enclosure made from the two cover layers may enclose the coils of a single coil module or of multiple coil modules.

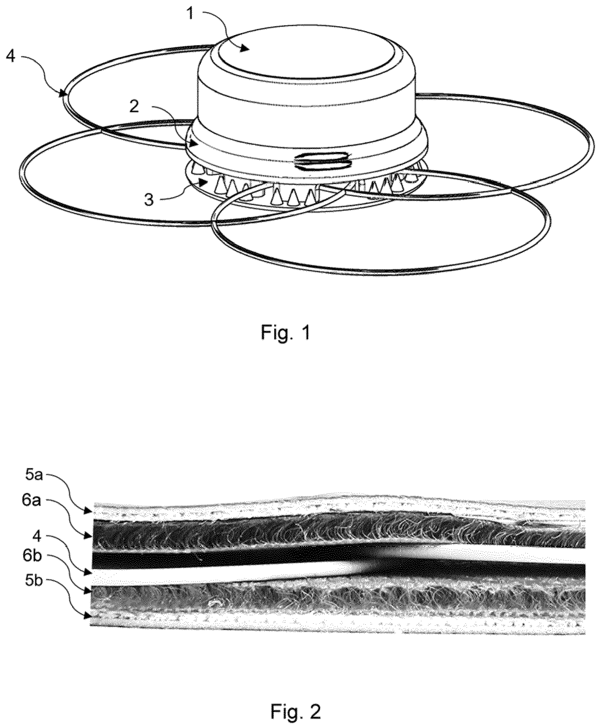

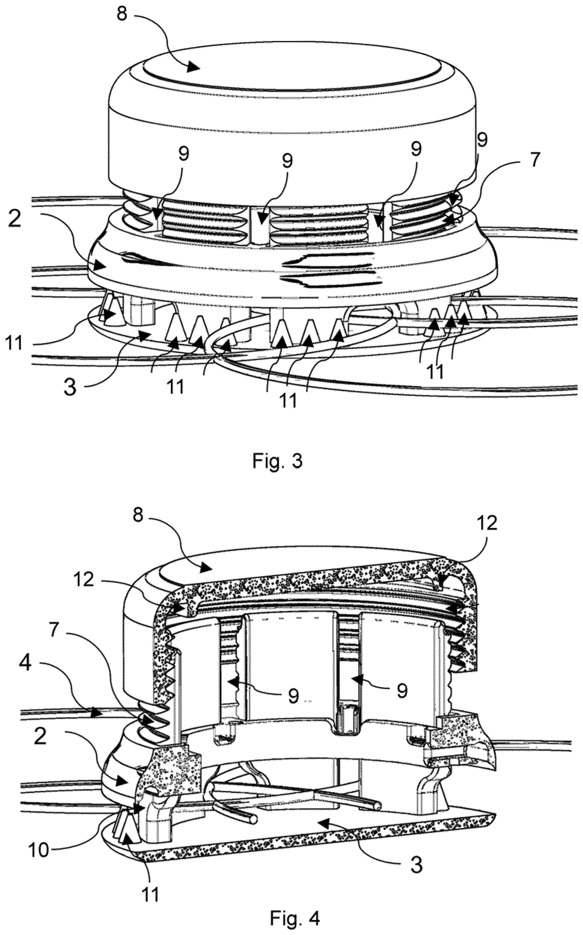

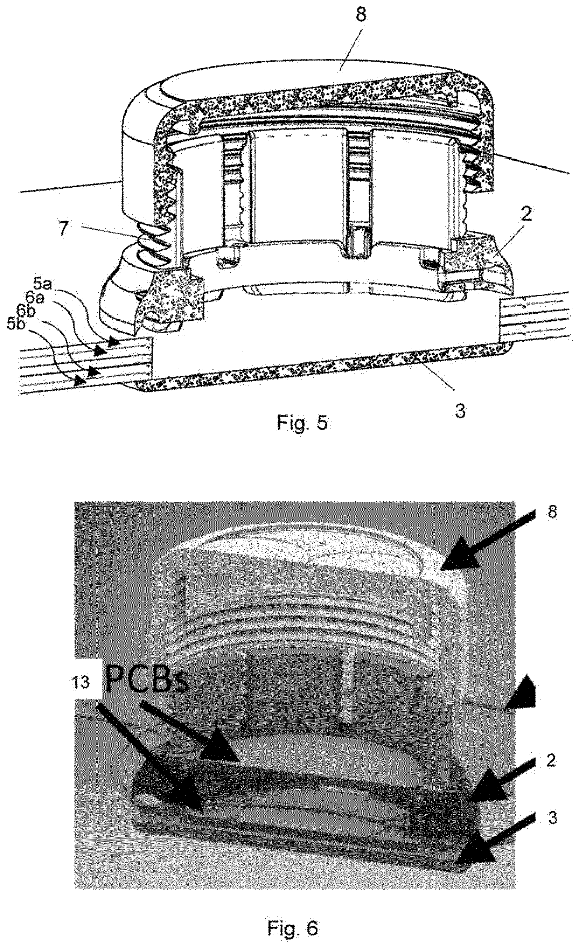

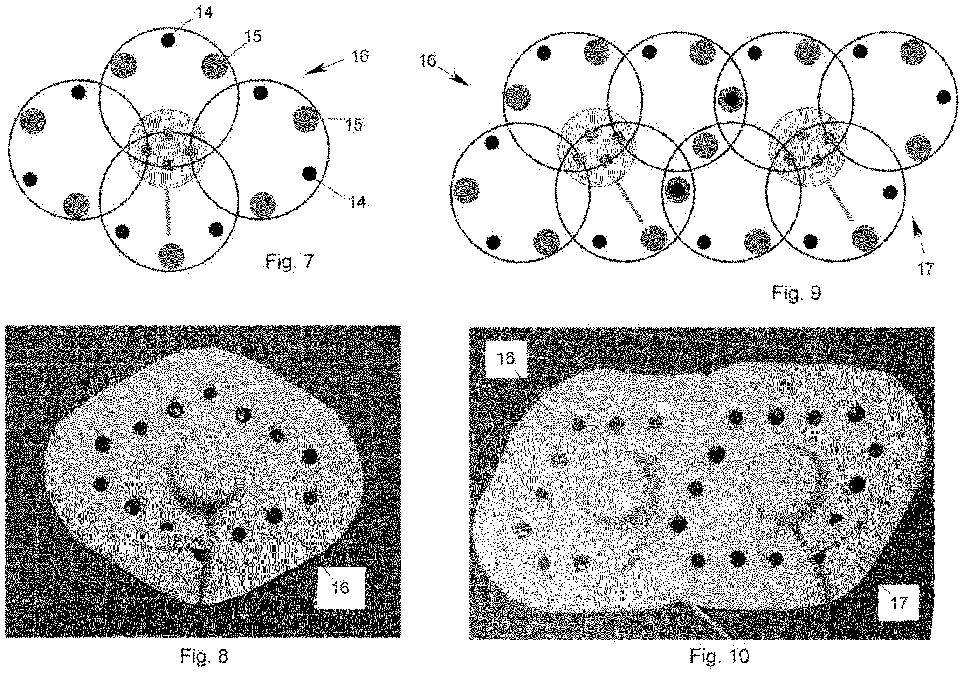

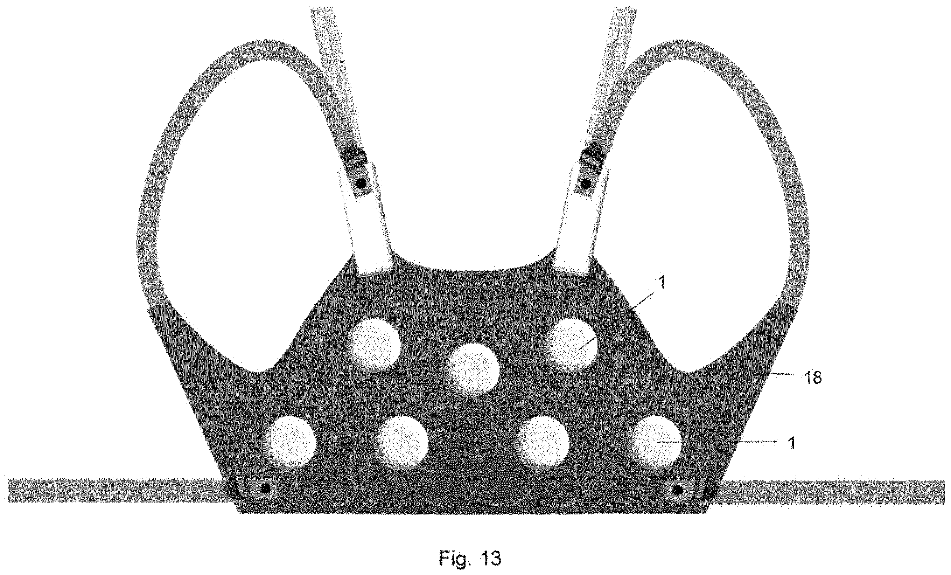

The invention will now be described in more detail with reference to the drawings. In the drawings, Fig. 1 shows a coil module of the invention without the cover layers, Fig. 2 shows the arrangement of cover layers, Fig. 3 shows a detailed view of the housing of the coil module of Fig. 1, Fig. 4 shows a cross section of the housing of Fig. 3, Fig. 5 shows a cross section of the housing with the cover layers, Fig. 6 shows a cross section of the housing with printed circuit boards, Fig. 7 shows a schematic illustration of the arrangement of the coils of a coil module, Fig. 8 shows a top view of the coil module of Fig. 7, Fig. 9 shows a schematic illustration of the arrangement of two adjacent coil modules, Fig. 10 shows a top view of the coil modules of Fig. 9, Figs. 11 and 12 shows various variations of coil arrays, and Fig. 13 shows a thorax vest with embedded coil modules.

Fig. 1 shows a housing 1 of a coil module, which comprises a base region 3 and a clamping ring 2. A gap is formed between the clamping ring 2 and the base region 3, through which four circular coils 4 emerge that overlap with each other. Further, the gap serves for receiving a plurality of layers, between which the coils 4 are arranged.

Fig. 2 shows an arrangement of several layers that are arranged below and above the coils 4. Specifically, an upper cover layer 5a forms the upper layer and a lower cover layer 5b forms a bottom layer. Further, a cushion layer 6a is arranged between the upper cover layer 5a and the coils 4 and a cushion layer 6b is arranged between the lower cover layer 5b and the coils 4.

Figs. 3 and 4 show the housing 1 in more detail. The housing comprises a main part 7 and a cover part 8, wherein the cover part 8 and the main part 7 have mating male and female threads for screwing the cover part 8 onto the main part 7. The main part 7 comprises guiding slits 9, into which guiding ribs of the clamping ring 2 engage in order to guide the clamping ring 2 in an axial direction. Upon screwing the cover part 8, the clamping member 2 is moved downwards towards the bottom region 3 of the housing. In this way, the clamping ring 2 is pressed against the upper cover layer 5a so that the arrangement of layers 5a, 5b, 6a, 6b and the coils 4 are clamped between the clamping ring 2 and the bottom region 3, as schematically shown in Fig. 5. In order to increase the clamping effect, the clamping ring 2 comprises a sharp edge 10 and the bottom region 3 comprises a plurality of spikes 11. As can be seen in Fig. 4, the cover part 8 comprises a stabilizing ring 12 that prevents the walls of the main part 7 to bend towards the inside of the housing and loosen the thread or break.

As shown in the cross-sectional view according to Fig. 6 two parallel circular printed circuit boards 13 are arranged within the housing which comprise the interfacing circuitry, to which the coils 4 are electrically connected, e.g. by soldering.

Fig. 7 is a schematic illustration of the arrangement of four coils 4 such that each coil overlaps its adjacent coil. The overlap is selected such that the mutual inductance is substantially zero. Further, male connecting elements 14 and female connecting elements 15 are alternately arranged in order to enable a connection of one coil module to an adjacent coil module, as depicted in Fig. 9. The connecting elements are arranged such that the coils 4 of the coil module 16 overlap with adjacent coils 4 of the adjacent coil module 17.

A top view of the coil modules 16 and 17 is shown in Figs. 8 and 10, wherein Fig 8 corresponds to the schematic illustration of Fig. 7 and Fig 10 corresponds to the schematic illustration of Fig. 9. As can be seen in Figs. 8 and 10, which shows the cover layers enclosing the coils 4, the cover layers are bonded to each other in their periphery so as to create a closed pocket that protects and electrically isolates the coils 4.

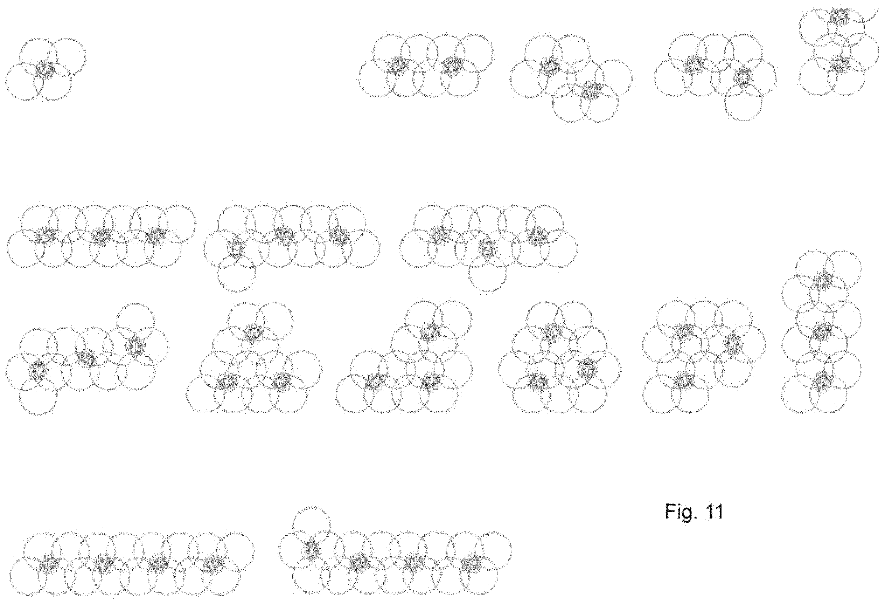

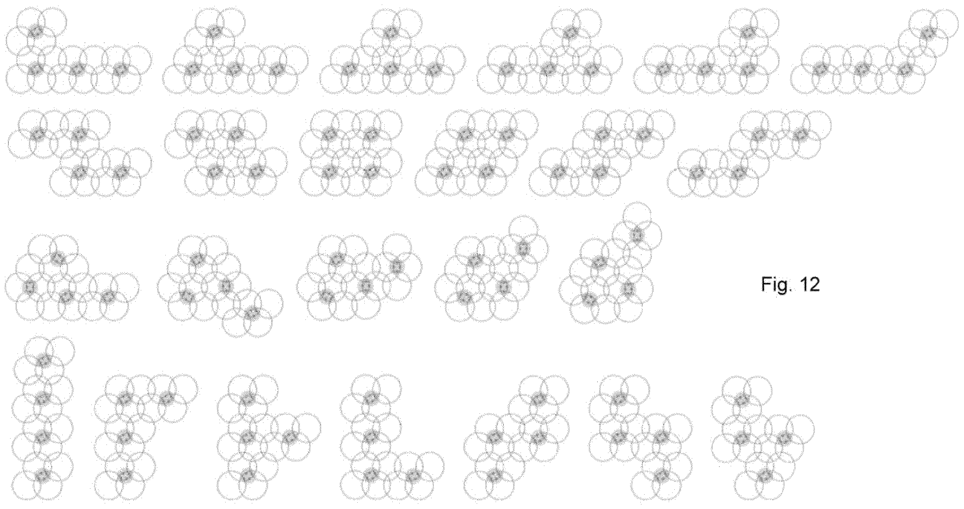

Identical coil modules may flexibly be connected in various configurations, as shown in Fig. 11 and 12.

Fig. 13 shows another embodiment, in which a plurality of coil modules are embedded into a piece of clothing, i.e. a vest for partly covering the thorax of a patient. The vest has a plurality of openings, which each receive a housing 1 of a coil module. A rim section of the opening is clamped between the clamping ring 2 and the bottom region 3 of the housing the same way as illustrated in the embodiment of Fig. 1-6. Further, the fabric 18 of the vest functions as the connecting means to connect and mutually position the plurality of coil modules.

## Claims

1. Coil module for magnetic resonance imaging applications, comprising:
- at least one flexible radio frequency coil,
- a housing, wherein said housing encloses an interfacing circuitry electrically connected to the at least one coil,
- two flexible cover layers for entirely covering the at least one coil outside said housing, wherein the at least one coil is arranged between said two cover layers, and
- connecting means for connecting the coil module to at least one adjacent coil module.

2. Coil module according to claim 1, wherein the at least one coil has a circular shape.

3. Coil module according to claim 1 or 2, wherein the coil module comprises at least two, preferably at least three, flexible radio frequency coils, wherein each of said coils overlaps with an adjacent coil, in particular such that the mutual inductance is substantially zero.

4. Coil module according to claim 1, 2 or 3, wherein the coil module comprises at least three flexible radio frequency coils, each coil having a circular shape with a center, wherein the centers of three of said at least three circular coils are arranged at corners of an equilateral triangle.

5. Coil module according to any one of claims 1 to 4, wherein the connecting means are arranged to obtain an overlap between a coil of the coil module and a coil of the adjacent coil module, in particular such that the mutual inductance is substantially zero.

6. Coil module according to any one of claims 1 to 5, wherein the connecting means comprise male and female connecting means that are designed to engage with each other, wherein the male and the female connecting means are arranged such that the male connecting means are engageable with the female connecting means, if the coil module is connected to an identical adjacent coil module.

7. Coil module according to any one of claims 1 to 6, wherein the connecting means are designed to define an orientation of the coil module relative to the adjacent coil module.

8. Coil module according to any one of claims 1 to 7, wherein the connecting means are designed for establishing a form-fit connection, such as snap buttons, zippers or hook-and-loop fasteners.

9. Coil module according to any one of claims 1 to 8, wherein the housing penetrates an opening in each of the two cover layers.

10. Coil module according to claim 9, wherein the housing comprises a clamping member for clamping each of the two cover layers in a rim section of the opening of the respective cover layer.

11. Coil module according to claim 10, wherein the housing comprises an annular gap between the clamping member and a base region of the housing, wherein the rim section of the opening of the two cover layers is each arranged within said gap, and wherein the clamping member is arranged to be pressed against said rim section.

12. Coil module according to claim 11, wherein the clamping member, on its side facing the base region of the housing, and the base region, on its side facing the clamping member, comprise protrusions, such as spikes, and/or a sharp edge.

13. Coil module according to claim 10, 11 or 12, wherein the housing comprises a main part and a cover part, wherein the cover part and the main part have mating male and female threads for screwing the cover part onto the main part, and wherein the clamping member is guided on the main part in a direction of an axis of said threads and arranged to be pressed against one of said two cover layers when the cover part is screwed relative to the main part.

14. Coil module according to any one of claims 1 to 13, wherein the at least one coil comprises a section that extends into the housing and is connected to the interfacing circuitry.

15. Coil module according to any one of claims 1 to 14, wherein the cover layers are made of a textile material or a fabric.

16. Coil module according to any one of claims 1 to 15, wherein a cushion layer is each arranged between a cover layer and the at least one coil.

17. An array of coils for magnetic resonance imaging applications, comprising at least two coil modules according to any one of claims 1 to 16, wherein said at least two coil modules are connected with each other by means of said connecting means, so that coils of the two coil modules overlap each other, in particular such that the mutual inductance is substantially zero.

18. Array according to claim 17, wherein the coils of said at least two coil modules have a circular shape with a center, wherein said at least two coil modules are arranged relative to one another such that a coil of one of the at least two coil modules, together with two adjacent coils of the other of the at least two coil modules, forms a set of three coils, the centers of the coils of said set of three coils being arranged at corners of an equilateral triangle.
